Europäisches Patentamt

(19) European Patent Office (11) Publication number: **0 256 150 B1**

Office européen des brevets

(12) **EUROPEAN PATENT SPECIFICATION**

(45) Date of publication of the patent specification: (51) Int. Cl.⁴: **H01L 21/18**
04.04.90

(21) Application number: **86111213.4**

(22) Date of filing: **13.08.86**

(54) Apparatus for bonding semiconductor wafers.

(43) Date of publication of application:
**24.02.88 Bulletin 88/8**

(45) Publication of the grant of the patent:
**04.04.90 Bulletin 90/14**

(84) Designated Contracting States:
**CH DE FR GB LI**

(56) References cited:
**EP-A- 0 129 732**
**EP-A- 0 161 740**
**FR-A- 2 343 330**

**IBM TECHNICAL DISCLOSURE BULLETIN, vol. 17, no. 6, November 1974, pages 1565,1566, New York, US; F.J.Smith, Jr.: "Chip transfer tool"**

(73) Proprietor: **KABUSHIKI KAISHA TOSHIBA, 72, Horikawa-cho Saiwai-ku, Kawasaki-shi Kanagawa-ken 210(JP)**

(72) Inventor: **Yoshikawa, Kiyoshi c/o Patent Division, K.K. Toshiba 1-1 Shibaura 1-chome, Minato-ku Tokyo 105(JP)**

(74) Representative: **Hansen, Bernd, Dr.rer.nat. et al, Hoffmann, Eitle & Partner Patentanwälte Arabellastrasse 4 Postfach 81 04 20, D-8000 München 81(DE)**

## Description

The present invention relates to an apparatus for bonding mirror surface finished semiconductor wafers.

In a typical technique used in the manufacture of semiconductor devices, a semiconductor layer of a specific conductivity type is formed on a semiconductor substrate by a CVD method and a functional element is formed in this region. In this CVD method, it is necessary to prevent an impurity from diffusing or mixing in from the substrate into the semiconductor layer.

Recently, a demand for an element with a high dielectric withstand voltage is high. Dielectric withstand voltage can be improved by thickening the semiconductor layer. However, it takes extremely long time to do this by the CVD method, and it is more difficult to prevent a diffusing of impurity.

In the invention described in Japanese Patent Publication No. 49-26455, semiconductor wafers are bonded such that semiconductor layers oppose each other, so as to prevent impurity mixing and to reduce manufacturing time as compared with the case wherein a semiconductor layer is formed using the CVD method. The method is performed as follows. Mirror surface finished semiconductor wafers are placed to oppose each other in an atmosphere of a gas mixture consisting of oxygen and nitrogen, and phosphorus is diffused into each mirror surface at a temperature of 1200°C for 30 minutes using phosphorus oxychloride as an impurity. The wafers are then heated at a temperature of 1150°C for an hour. After placing the wafers in a vacuum, the wafers are bonded at a pressure of 150 kg/cm² and a temperature of 1300°C.

However, when a bonding temperature is higher than that during diffusion as described above, the diffusion impurity is redistributed during bonding to change a surface concentration of an impurity layer. In addition, wafer alignment in a vacuum is difficult to perform and results in high cost.

In order to solve the above problem, a method of bonding wafers in air at room temperature is disclosed by the present inventor in "Nikkei Electronics", January 27, 1986, p. 108 to 110. In this method, after the mirror surfaces of wafers are washed with water and excess water is removed, the wafers are bonded together in a clean atmosphere utilizing residual water on the mirror surfaces. According to this method, impurity redistribution is prevented and wafer alignment is easy.

However, in this method, air bubbles are left between wafers to form voids in their interfaces.

A device is known from FR-A 2 343 330 for holding and deforming a semiconductor wafer using a vacuum. The semiconductor wafer is slightly bent into a dome shape by being sucked against a convex surface, prior to bonding of the wafers. The method reduces the possibility of entrapping air.

It is an object of the present invention to provide an apparatus for bonding wafers without forming voids even when wafers are bonded in air at room temperature.

The object of the present invention is solved by an apparatus for bonding semiconductor wafers comprising:

first and second tables having first and second elastic bases each of which has upper and lower surfaces, and a plurality of through holes extending from the upper to the lower surfaces thereof, and, in operation, a semiconductor wafer having a mirror surface being mounted with the mirror surface facing up on each said upper surface;

a suction mechanism reducing pressure in said through holes and chucking the semiconductor wafers to said bases;

a projecting mechanism provided to face the lower surface of at least said second base and urging the surface to elastically deform said base corresponding thereto, thereby projecting a central portion of said base to project a central portion of the mirror surface of the semiconductor wafer;

first and second support mechanisms supporting said first and second tables and said projecting mechanism; and

drive means moving said first and second support mechanisms relative to each other and pressing the mirror surfaces of the semiconductor wafers against each other.

This invention can be more fully understood from the following detailed description when taken in conjunction with the accompanying drawings, in which:

Fig. 1 is a perspective view schematically showing a wafer bonding system which uses a bonding apparatus according to an embodiment of the present invention;

Fig. 2 is a partially broken side view showing a bonding apparatus according to the embodiment of the present invention with wafers mounted and chucked;

Fig. 3 is a partially broken side view showing the apparatus with wafers opposing each other and the center of a mirror surface of an upper wafer projecting;

Figs. 4A to 4C are sectional views showing a part of the apparatus in each step which illustrates a method of bonding wafers; and

Fig. 5 is a sectional view showing a part of a modified mechanism.

An embodiment of the present invention will now be described with reference to the accompanying drawings.

Fig. I shows a wafer bonding system which uses a wafer bonding apparatus of the present invention comprising first and second supports 2 and 4. Rectangular enclosure 8 with an open front and a transparent top and clean unit I0 positioned therebehind are provided on pedestal 6. A filter (not shown) which cleans air supplied horizontally from a blower of the clean unit to the enclosure is provided between unit I0 and enclosure 8. With this mechanism, the interior of enclosure 8 is kept clean. In enclosure 8 on pedestal 6, first and second supports 2 and 4 are installed adjacent and opposite each other and panel I2 and TV monitor I4 are spaced apart from supports 2 and 4. Monitor camera I6 is positioned at a distance of, e.g., 500 mm from and above the top surface of enclosure 8. Operations of supports 2 and 4 are monitored by camera I6 and displayed on TV monitor I4. Operations of supports 2 and 4 can be controlled by observing TV monitor I4 and operating panel I2.

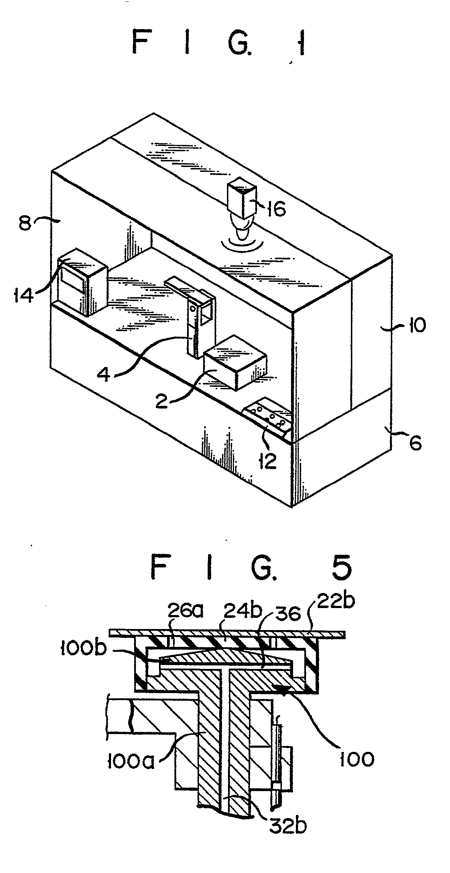

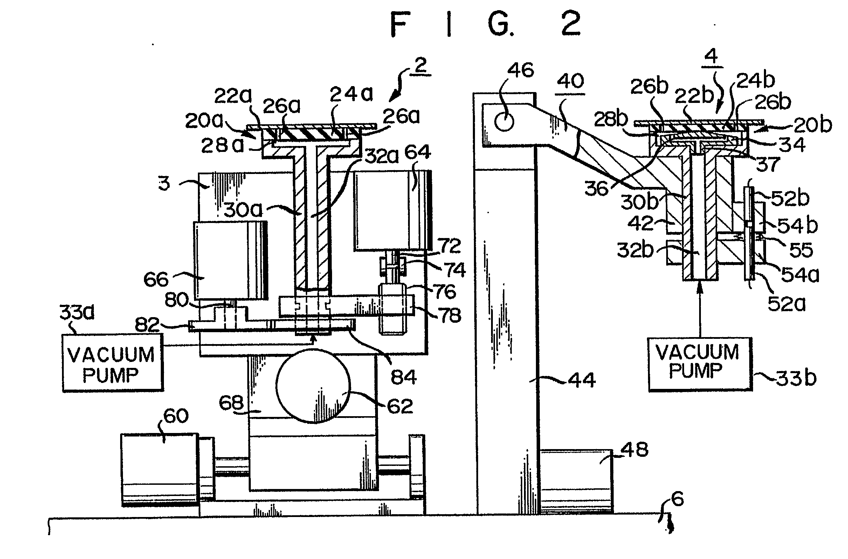

As shown in Fig. 2, first and second supports 2 and 4 have first and second chuck tables 20a and 20b, respectively. Tables 20a and 20b comprise disk-like first and second elastic bases 24a and 24b. Base 24a and 24b have flat surfaces on which semiconductor wafers 22a, 22b are mounted with their mirror surfaces facing up. Bases 24a and 24b may be made of an elastic material such as rubber, or a material which is not elastic itself but imparts elasticity upon being formed into a thin member. Bases 24a and 24b have a plurality of through holes 26a and 26b, respectively. These holes are preferably formed near the periphery of the base such that the center of the base is conveniently projected. Tables 20a and 20b have support members 30a and 30b which support bases 24a and 24b on their upper surfaces, respectively. Members 30a and 30b are cylindrical with their upper portions enlarged horizontally. Cavities 28a and 28b whose upper surfaces are closed by elastic bases 24a and 24b are formed in the upper portions of support members 30a and 30b. Paths 32a and 32b are respectively formed in support members 30a and 30b so that their upper ends communicate with cavities 28a and 28b and their lower ends are open at the lower surfaces of support members 30a and 30b. Projecting member 34 which faces the other surface of base 24b and projects at the center thereof is vertically movably housed in cavity 28b of table 20b of support 4. More specifically, an upper surface of projecting member 34 is conical. Columnar sliding portion 37 projects from the lower surface of projecting portion 34 and is slidable with respect to the inner upper wall of path 32b of support member 30b. Path 36 is formed in projecting member 34 so that its lower end is open at the lower surface of sliding portion 37 and its upper end at the conical surface. Path 36 normally communicates cavity 28b with path 32b. Lower ends of paths 32a and 32b of support members 30a and 30b are respectively communicated with vacuum pumps 33a and 33b for evacuating paths 32a and 32b. Wafers 22a and 22b respectively mounted on bases 24a and 24b are drawn upon operation of vacuum pumps through paths 32a and 32b, cavities 28a and 28b, and holes 26a and 26b, and are chucked to surfaces of bases 24a and 24b.

Support member 30b is slidably fitted in a vertical through hole in bracket 42 mounted on one end of rotat ing arm 40. In the state shown in Fig. 2, support member 30b is held such that its lower surface is in contact with the upper surface of bracket 42. First fixing member 54a is mounted on a lower portion of support member 30b projecting from the lower end of bracket 42, and fixes at its one end first terminal 52a constituting a contact sensor for wafers. Second terminal 52b cooperates with terminal 52a to constitute the sensor. Terminal 52b is coaxial and at a predetermined distance from terminal 52a, and is fixed by second fixing member 54b projecting horizontally on the lower portion of bracket 42 of arm 40. The contact sensor generates an electrical signal when its terminals are not in contact with each other. The contact sensor is electrically connected to a motor so as to close a drive circuit of a Z pulse motor which is described later, and to a drive circuit of a vacuum pump for evacuating a pedestal so as to stop the operation of the pump by an electrical signal. Coil spring 55 is arranged between fixing members 54a and 54b so as to bias first fixing member 54a downwardly.

Arm 40 is mounted through shaft 46 on arm support column 44 whose lower portion is fixed to pedestal 6 so as to pivot about the shaft in a vertical plane. Shaft 46 is rotated by motor 48 via a known transmission mechanism in column 44.

First support 2 comprises block 3 which supports table 20a to be rotatable and vertically movable, and X, Y, Z, and θ pulse motors 60, 62, 64, and 66. Motors 60 and 62 can move X-Y stage 68 horizontally, i.e., in X and Y directions by desired amounts. Block 3 is mounted on X-Y stage 68 to move therewith. Z and θ moving mechanism is installed in block 3. Bolt 76 is connected through joint member 74 to rotating shaft 72 of motor 64 which is fixed to block 3. Bolt 76 is screwed into a female threaded through hole formed in lift plate 78. The lift plate is connected to support member 30a to be free from rotation of support member 30a and interlocked with vertical movement thereof. In order to provide this connection, a connecting mechanism comprising a recess which is formed at an outer periphery of support member 30b and engageable with a projection provided on plate 78 can be adopted.

First gear 82 is coaxially mounted on rotating shaft 80 of motor 66 which is fixed to block 3. Gear 82 is meshed with second gear 84 which is coaxially mounted on the lower portion of support member 30a. Gears 82 and 84 are arranged such that gear 82 is meshed with gear 84 and is free from vertical movement thereof.

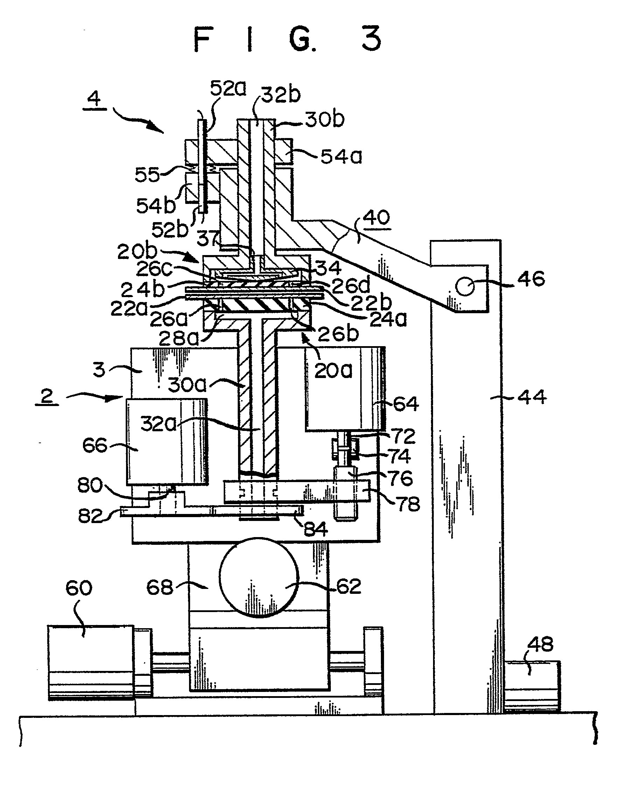

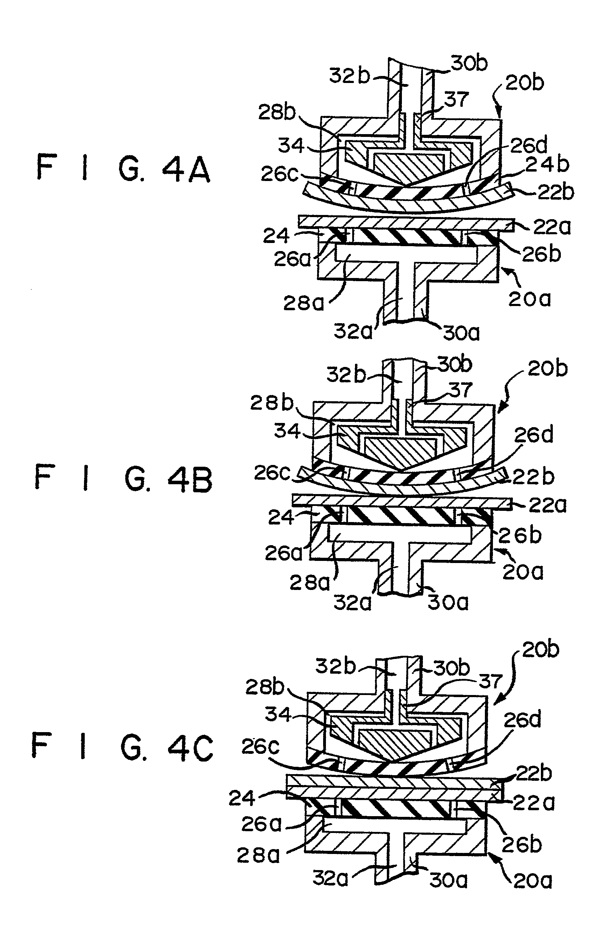

A method of bonding semiconductor wafers using a bonding apparatus having the above construction will now be described with reference to Figs. 3 and 4A to 4C.

Wafers 22a and 22b having mirror surface finished upper surfaces are respectively chucked on first and second elastic bases 24a and 24b by evacuating table 20a and 20b. Next, as shown in Fig. 3, motor 48 is driven to pivot arm 40 counterclockwise through I80°. As a result, second support member 30b moves downwardly against the biasing force of spring 55 by its own weight and is held where first terminal 52a is in contact with second terminal 52b. In addition, projecting member 34 moves downwardly by its own weight and urges base 24b such that the center portion thereof projects downwardly. It will be obvious that vertical alignment of support member 30b and a projection action of the wafer can be achieved automatically by pivoting arm 40 through I80°. In this state, support member 30a is horizontally shifted and pivoted by driving and controlling X, Y, and θ motors 60, 62, and 66 to match orientation flats of both wafers. Next, Z motor 64 is driven to move support member 30a upwardly to bring wafer 22a into contact with the central portion of wafer 22b, as shown in Fig. 4B. By this contact, the second wafer or the second support member is slightly shifted upwardly, terminals 52a and 52b are disconnected, and an electric signal is generated to stop motor 64 and the vacuum pumps. As a result, wafer 22b whose central portion projects downwardly is released from suction by base 24b. The periphery of wafer 22b moves downwardly to regain its flatness as a whole, and the entire surface thereof is brought into contact with wafer 22a. In this case, a bonding region of wafers 22a and 22b extends from the central portion to the periphery to prevent air bubbles from being trapped in the interface. The present invention is not limited to the above embodiment, and various changes and modifications may be made without departing from the scope of the present invention. For instance, a projecting member may be arranged so as to project lower wafers, or the central portions of two wafers may be projected. In this case, a means for moving the projecting members is required. In the above embodiment, a semiconductor wafer is projected and then moved to be brought into contact with another semiconductor wafer at their central portions. However, semiconductor wafers may be brought into contact with each other by projecting the central portion(s) of the wafer(s).

In the above embodiment, the projecting member and the support member are provided independently of each other. However, they may be formed as an integral structure, as will be described with reference to Fig. 5.

Cylindrical support member 100 is formed such that it has lower portion 100a, which extends through bracket 42 and is slidable in the axial direction thereof, and upper portion 100b, which is projected from the upper surface of bracket 42 and has a diameter larger than that of lower portion 100a. The upper surface of upper portion 100b is formed to be conical, thus forming a projecting member. Straight path 36 is provided in upper portion 100b such that it is open at the circumference of upper portion 100b. This path communicates with path 32b provided in lower portion 100a. Cylindrical support base 24b, made of an elastic material such as rubber, is attached to the upper portion of support member 100 such that the interior of support base 24b defines a space sealed by upper portion 100b. Support base 24b is provided with through holes 26a at a position shifted from the center thereof.

With the support member having the above construction, if the air in the support base 24b through paths 32b and 36 is sucked, the upper wall of support base 24b is pulled to support member 100 and deformed into a conical shape that conforms with the shape of the upper portion of support member 100. At this time, wafer 22b is deformed together with elastic member 24b in such a manner that the peripheral portions of wafer 22b are pulled toward the projecting member more greatly than the central portion. Accordingly, the central portion of wafer 22b is projected, as in the embodiment described above.

## Claims

1. An apparatus for bonding semiconductor wafers comprising:

first and second tables (20a, 20b) having first and second elastic bases (24a, 24b) each of which has upper and lower surfaces, and a plurality of through holes (26a, 26b) extending from the upper to the lower surfaces thereof, and, in operation, a semiconductor wafer (22a, 22b) having a mirror surface being mounted with the mirror surface facing up on each said upper surface;

a suction mechanism (33a, 33b) reducing pressure in said through holes and chucking the semiconductor wafers to said bases;

a projecting mechanism (34) provided to face the surface of at least said second base and lower urging the lower surface to elastically deform said base corresponding thereto, thereby projecting a central portion of said base to project a central portion of the mirror surface of the semiconductor wafer;

first and second upper mechanism (30a, 30b) supporting said first and second tables and said projecting mechanism; and

drive means (33a, 33b) moving said first and second support mechanism relative to each other and pressing the mirror surfaces of the semiconductor wafers against each other.

2. An apparatus according to claim 1, characterized in that said first and second elastic bases (24a, 24b) are supported at one end of the first and second support mechanisms, the support mechanisms having shafts and paths (32a, 32b) which communicate with said through holes (26a, 26b) of said bases, and said suction mechanism evacuates said paths of said first and second support mechanisms to reduce pressure in said through holes.

3. An apparatus according to claim 1 or 2, characterized in that said first support mechanism has a block (3) which supports said first table (20a) pivotally about an axis and movably along the axis.

4. An apparatus according to claim 3, characterized in that said drive means comprises a rotating mechanism (66, 80, 82, 84) for rotating said first table with respect to the block and a moving mechanism (64, 72, 76, 78) for axially moving said first table with respect to said block.

5. An apparatus according to claim 3 or 4, characterized in that said apparatus comprises an X-Y table (68) having said block thereon.

6. An apparatus according to claim 2, characterized in that said second support mechanism comprises an arm (40) for axially and movably supporting said second table (20b) and a support column (44) for pivotally supporting said arm, and said drive means comprises an arm pivoting mechanism (48) for pivoting said arm to allow the semiconductor wafer on said second elastic base to face the semiconductor wafer on said first elastic base.

7. An apparatus according to claim 6, characterized in that said projecting mechanism comprises a projecting member (34) provided axially and movably in a path of said second table and having at a center of one end surface thereof a projection capable of being brought into contact with the other surface of said second elastic base.

8. An apparatus according to claim 7, characterized in that one end surface of said projecting member (34) is conical.

9. An apparatus according to any one of claims 1 to 8, which comprises a sensor (52a, 52b) which senses the contact between the central portions of said semiconductor wafers and thereupon releases evacuation in said through holes of the second elastic base.

## Revendications

1. Appareil de collage de tranches semi-conductrices, comprenant:

une première et une seconde table (20a, 20b) ayant une première et une seconde base élastique (24a, 24b) ayant chacune une surface supérieure et une surface inférieure, et plusieurs trous débouchants (26a, 26b) disposés entre les surfaces supérieures et inférieures, et, pendant le fonctionnement, une tranche semi-conductrice (22a, 22b) ayant une surface de miroir étant destinée à être montée avec sa surface de miroir tournée vers le haut sur chaque surface supérieure,

un mécanisme d'aspiration (33a, 33b) réduisant la pression dans les trous débouchants et fixant les tranches semi-conductrices sur les bases, un mécanisme (34) de mise en saillie destiné à être tourné vers la surface inférieure de la seconde base au moins et repoussant la surface inférieure afin que la base se déforme élastiquement d'une manière correspondante si bien qu'une partie centrale de la base est mise en saillie et met en saillie une partie centrale de la surface de miroir de la tranche semi-conductrice,

un premier et un second mécanisme de support (30a, 30b) supportant la première et la seconde table et le mécanisme de mise en saillie, et

un dispositif d'entraînement (33a, 33b) déplaçant le premier et le second mécanisme de support l'un par rapport à l'autre et repoussant les surfaces de miroir des tranches semi-conductrices l'une contre l'autre.

2. Appareil selon la revendication 1, caractérisé en ce que la première et la seconde base élastique (24a, 24b) sont supportées à une première extrémité du premier et du second mécanisme de support, les mécanismes de support ayant des arbres et des trajets (32a, 32b) qui communiquent avec les trous débouchants (26a, 26b) des bases, et le mécanisme d'aspiration évacue ces trajets des premier et second mécanismes de support afin que la pression soit réduite dans les trous débouchants.

3. Appareil selon la revendication 1 ou 2, caractérisé en ce que le premier mécanisme de support a un bloc (3) qui supporte la première table (20a) afin qu'elle puisse pivoter autour d'un axe et qu'elle puisse se déplacer le long de cet axe.

4. Appareil selon la revendication 3, caractérisé en ce que le dispositif d'entraînement comporte un mécanisme d'entraînement en rotation (66, 80, 82, 84) destiné à faire tourner la première table par rapport au bloc, et un mécanisme de déplacement (64, 72, 76, 78) destiné à déplacer axialement la première table par rapport au bloc.

5. Appareil selon la revendication 3 ou 4, caractérisé en ce qu'il comprend une table X–Y (68) sur laquelle est placé le bloc.

6. Appareil selon la revendication 2, caractérisé en ce que le second mécanisme de support comporte un bras (40) destiné à supporter axialement la seconde table (20b) afin qu'elle soit mobile et une colonne de support (44) destinée à supporter le bras afin qu'il puisse pivoter, et le dispositif d'entraînement comprend un mécanisme (48) destiné à faire pivoter le bras afin que la tranche semi-conductrice portée par la seconde base élastique puisse être placée en face de la tranche semi-conductrice portée par la première base élastique.

7. Appareil selon la revendication 6, caractérisé en ce que le mécanisme de mise en saillie comporte un organe (34) de mise en saillie disposé axialement sur le trajet de la seconde table afin qu'il puisse se déplacer par rapport à ce trajet, et ayant, au centre d'une surface d'extrémité, une saillie qui peut être mise au contact de l'autre surface de la seconde base élastique.

8. Appareil selon la revendication 7, caractérisé en ce que la surface d'extrémité de l'organe de mise en saillie (34) a une forme conique.

9. Appareil selon l'une quelconque des revendications 1 à 8, qui comprend un capteur (52a, 52b) qui détecte le contact entre les parties centrales des tranches semi-conductrices puis supprime l'évacuation par les trous débouchants de la seconde base élastique.

## Patentansprüche

1. Gerät zum Zusammenfügen von Halbleiterscheiben enthaltend:

erste und zweite Tische (20a, 20b) mit ersten und zweiten elastischen Unterlagen (24a, 24b), die jeweils obere und untere Oberflächen und eine Vielzahl sich von der oberen bis zu der unteren dieser Oberflächen erstreckenden Durchgangslöcher (26a, 26b) aufweisen, wobei in Betrieb eine Halbleiterscheibe (22a, 22b) mit einer Spiegeloberfläche mit der Spiegeloberfläche nach oben auf jeder oberen Oberfläche montiert ist;

einen Saugmechanismus (33a, 33b), der den Druck in den Durchgangslöchern reduziert und die Halbleiterscheiben auf den Unterlagen einspannt;

einen Ausfahrmechanismus (34), der gegenüber der unteren Oberfläche von wenigstens der zweiten Unterlage vorgesehen ist und auf die untere Oberfläche drückt, um die dazu zugehörigen Unterlage zu deformieren, wodurch ein zentraler Teil der Unterlage vorsteht, um einen zentralen Teil der Spiegeloberfläche der Halbleiterscheibe vorstehen zu lassen;

erste und zweite Trägermechanismen (30a, 30b), die die ersten und zweiten Tische und den Ausfahrmechanismus tragen; und

Antriebsmittel (33a, 33b), die die ersten und zweiten Trägermechanismen relativ zueinander bewegen und die Spiegeloberflächen der Halbleiterscheiben gegeneinander drücken

2. Gerät nach Anspruch 1, dadurch dadurch gekennzeichnet, daß die ersten und zweiten elastischen Unterlagen (24a, 24b) an einem Ende der ersten und zweiten Trägermechanismen unterstützt sind, wobei die Trägermechanismen Achsen und Wege (32a, 32b) aufweisen, die mit den Durchgangslöchern (26a, 26b) der Unterlagen in Verbindung stehen, und der Saugmechanismus die Wege der ersten und zweiten Trägermechanismen evakuiert, um den Druck in den Durchgangslöchern zu reduzieren.

3. Gerät nach Anspruch 1 oder 2, dadurch gekennzeichnet, daß der erste Trägermechanismus einen Block (3) aufweist, der den ersten Tisch (20a) um eine Achse drehbar und entlang der Achse bewegbar trägt.

4. Gerät nach Anspruch 3, dadurch gekennzeichnet, daß die Antriebsmittel einen Drehmechanismus (66, 80, 82, 84) zum Rotieren des ersten Tisches in bezug auf den Block und einen Bewegungsmechanismus (64, 72, 76, 78) zum axialen Bewegen des ersten Tisches in bezug auf den Block enthalten.

5. Gerät nach Anspruch 3 oder 4, dadurch gekennzeichnet, daß das Gerät einen X–Y Tisch (68) mit einem Block hierauf aufweist.

6. Gerät nach Anspruch 2, dadurch gekennzeichnet, daß der zweite Trägermechanismus einen Arm (40) zum axialen und bewegbaren Tragen des zweiten Tisches (20b) und eine Trägersäule (44) zum drehbaren Tragen des Arms enthält, und die Antriebsmittel einen armdrehenden Mechanismus (48) zum Drehen des Arms enthalten, um der Halbleiterscheibe auf der zweiten elastischen Unterlage zu erlauben, daß sie gegenüber der Halbleiterscheibe auf der ersten elastischen Unterlage liegt.

7. Gerät nach Anspruch 6, dadurch gekennzeichnet, daß der Ausfahrmechanismus ein Ausfahrglied (34) enthält, das axial und bewegbar in einem Weg des zweiten Tisches vorgesehen ist und in einem Zentrum einer seiner Stirnflächen einen Vorsprung aufweist, der in Kontakt mit der anderen Oberfläche der zweiten elastischen Unterlage bringbar ist.

8. Gerät nach Anspruch 7, dadurch gekennzeichnet, daß eine Stirnfläche des Ausfahrglieds (34) konisch ist.

9. Gerät nach einem der Ansprüche 1 bis 8, gekennzeichnet durch einen Sensor (52a, 52b), der den Kontakt zwischen den zentralen Teilen der Halbleiterscheiben erfaßt und hierauf die Evakuierung in den Durchgangslöchern der zweiten elastischen Unterlage abstellt.

F I G. 1

F I G. 5

# F I G. 2

EP 0 256 150 B1

# F I G. 3

EP 0 256 150 B1

F I G. 4A

F I G. 4B

F I G. 4C